Europäisches Patentamt

European Patent Office

Office européen des brevets

(19)

(11) Veröffentlichungsnummer: **0 004 557**
**B1**

(12) **EUROPÄISCHE PATENTSCHRIFT**

(45) Veröffentlichungstag der Patentschrift: **23.12.81**

(21) Anmeldenummer: **79100623.2**

(22) Anmeldetag: **02.03.79**

(51) Int. Cl.³: **G 11 C 11/24,**
G 11 C 17/06, G 11 C 7/00,
H 01 L 27/04

(54) Kapazitiver, integrierter Halbleiterspeicher.

(30) Priorität: **03.04.78 US 892605**

(43) Veröffentlichungstag der Anmeldung:
**17.10.79 Patentblatt 79/21**

(45) Bekanntmachung des Hinweises auf die Patenterteilung:
**23.12.81 Patentblatt 81/51**

(84) Benannte Vertragsstaaten:
**BE CH DE FR GB NL SE**

(56) Entgegenhaltungen:
**DE - A - 2 721 851**
**DE - A - 2 725 613**
**DE - B - 2 204 550**
**US - A - 3 979 734**
**US - A - 3 992 703**

(73) Patentinhaber: **International Business Machines
Corporation
Armonk, N.Y. 10504 (US)**

(72) Erfinder: **Lee, Hsing-San
100 Lamplite Lane
Williston VT 05495 (US)**
Erfinder: **Pricer, Wilbur David
58 Van Patten Parkway
Burlington VT 05401 (US)**
Erfinder: **Vogl, Norbert George, Jr
18 Biscayne Heights Road No. 2
Winooski VT 05404 (US)**

(74) Vertreter: **Böhmer, Hans Erich, Dipl.-Ing.
Schönaicher Strasse 220
D-7030 Böblingen (DE)**

Courier Press, Leamington Spa, England.

## Kapazitiver, integrierter Halbeiterspeicher

Die Erfindung betrifft einen kapazitiven, integrierten Halbleiterspeicher mit auf einem Halbleitersubstrat angeordneten, über Wort- und Bitleitungen ansteuerbaren Speicherzellen sowie mit einer Anzahl Steuerschaltungen zum Einschreiben und Auslesen von Information, bei welchem auf dem Halbleitersubstrat eine erste Isolierschicht und zur Bildung von Speicherkondensatoren über dieser eine Anzahl von parallel verlaufenden, voneinander auf Abstand liegenden Leiterstreifen vorgesehen sind, die über die Bit-/Abfühlleitungen mit den Steuerschaltungen verbunden sind, während über einer weiteren Isolierschicht zu den Leiterstreifen orthogonal verlaufende Wortleitungen vorgesehen sind, wobei in dem Halbleitersubstrat die Anordnung der Speicherkondensatoren zu beiden Seiten durch eine Diffusionszone begrenzt ist, die über eine Impulquelle ansteuerbar ist. Ein derartiger Halbleiterspeicher ist beispielsweise aus der DE—A—27 11 542 bekannt. Gemäß dieser DE—A—27 11 542 werden die Ladungen von einer Ladungsquelle in form von Impulsen erzeugt, die anstelle von Gleichspanungsladungen in die Speicherkondensatoren injiziert werden. Dabei sind im Gebiet von Kreuzungspunkten der Ansteuerleitungen, d.h. der Bit-Leitungen und der Wortleitungen Inversions-Speicher-Kondensatoren gebildet. Die Wortleitungen sind an den einen Kondensatorbelegen und die Bitleitungen sind an den anderen Kondensatorbelegen angeschlossen.

Integrierte Halbleiter-Speicherschaltungen mit Zellen, die zur Speicherung einen Speicherkondensator und einen Schalter enthalten, haben zu sehr hohen Speicherzellendichten geführt. Eine der einfachsten Schaltungen für kleine Speicherzellen ist in der der Anmelderin gehörenden US—A—3 387 286 beschrieben. Jede dieser Zellen verwendet einen Speicherkondensator und einen als Schalter wirkenden Feldeffekttransistor für einen selektiven Anschluß des Kondensators an eine Bit-/Abfühlleitung. In den ebenfalls der Anmelderin gehörenden US—A—3 811 076 und US—A—3 841 926 ist eine Feldeffekttransistor-Speicherzelle der oben beschriebenen Art mit nur einem Feldeffekttransistor beschrieben, deren Abmessungen dadurch kleingehalten sind, daß zur Bildung eines Speicherkondensators eine Schicht aus dotiertem polykristallinem Silicium vorgesehen ist, die von dem Halbleitersubstrat durch eine auf der Oberfläche des Substrats angebrachte dieelektrische Schicht getrennt ist.

In der der Anmelderin gehörenden US—A—3 979 734 ist eine Speicheranordnung aus kleinen Zellen beschrieben, die aus Speicherkondensatoren und bipolaren Transistoren bestehen. In dieser Speicheranordnung ist eine Klemme oder ein Beleg eines jeden Speicherkondensators dieser Zellen an einer gesonderten Bit-/Abfühlleitung angeschlossen, während ausgewählte, ein Wort bildende Zellen gleichzeitig dadurch angesteuert werden, daß ein Wortimpuls für die Ankopplung an die andere Klemme oder den anderen Beleg des Speicherkondensators dieses Wortes benutzt wird.

In der ebenfalls der Anmelderin gehörenden US—A—4 080 590 ist eine Speicheranordnung mit Unipolar-Technik beschrieben, die aus sehr kleinen Kondensatorzellen aufgebaut ist, wobei jede der Zellen im wesentlichen nur einen kleinen Speicherkondensator enthält, eine Bit-/Abfühlleitung an einer Klemme des Kondensators angeschlossen ist und eine Wortleitung der Ankopplung an die andere Klemme des Kondensators dient. In einer dort beschriebenen Ausführungsform wird auf der Oberfläche eines Halbleitersubstrats eine aus Ladungen bestehende Gleichstromquelle gebildet, und es wird in einem Abstand von dieser Ladungsquelle eine Anzahl von Inversions-Speicherkondensatoren auf der Oberfläche des Halbleitersubstrats angeordnet. Binäre Werte darstellende Spannungsimpulse werden an einer Klemme der Kondensatoren zugeführt, und die andere Klemme der Kondensatoren ist mit der Gleichstromquelle der Ladungen über das Anlegen eines Wortimpulses an eine Wortleitung gekoppelt.

Halbleiterspeicher hat man bisher allgemein in zwei Dimensionen angesteuert, wobei eine einzige Wortleitung eine Anzahl von Speicherzellen ansteuert und jede Speicherzelle über eine Bit-/Abfühlleitung an einer Eingabe/Ausgabe- oder Steuerschaltung angeschlossen ist. Es ist jedoch aus dem Stand der Technik, insbesondere von Magnetspeichern, bekannt, daß die Eingabe/Ausgabe- oder Steuerschaltung an mehr als einer Bit-/Abfühlleitung angeschlossen werden kann, wodurch sich einige räumliche Vorteile ergeben. Eine derartige Anordnung ist manchmal als 2-1/2-dimensional bezeichnet worden, und eine Beispiel dafür findet sich in einem Aufsatz in IBM Technical Disclosure Bulletin, Band 10, Nr. 6, vom November 1967, Seiten 776 und 777 sowie in der US-Patentschrift 3 693 76.

In der oben erwähnten US-Patenschrift 3 979 734 ist auch eine 2-1/2-dimensionale Ansteuerung offenbart, die in Verbindung mit dem Betrieb des dort gezeigten bipolaren Speichers benutzt werden kann. In einem derartigen 2-1/2-dimensional betriebenen bipolaren Speicher können die Leitungen in Segmente unterteilt sein, und ein Verstärker kann zur Verstärkung der aus mehreren Zellen kommenden Signale verwendet werden.

Der Erfindung liegt also die Aufgabe zugrunde, eine verbesserte Speicheranordnung in integrierter Schaltungstechnik gemäß DE—A—2 711 542 zu schaffen, bei der jeweils eine kleine Anzahl von Zellen an einer Wortleitung, wie zum Beispiel 1 Byte, zum Lesen und Schreiben ausgewählt werden kann, ohne daß dabei die anderen Zellen an dieser Wortleitung gestört werden. Dabei sollen vor allem die Steuerschaltungen mit den Abfühlverstärkern und den Bittreibern mehrfach ausgenützt werden. Dadurch sind dann weniger Abfühlverstärker erforderlich als Bit-/Abfühlleitungen vorhanden sind. Diese Anordnung ergibt dann die Möglichkeit, nicht ausgewählte, jedoch einer ausgewählten Wortleitung zugeordnete Bit-/Abfühlleitungen für eine Störungsunterdrückung an Abfühlverstärker anzuschließen.

Dies wird erfindungsgemäß dadurch erreicht, daß die Leiterstreifen jeweils zu Gruppen zusammengefaßt sind, wobei jede Gruppe jeweils zwischen zwei Diffusionszonen angeordnet ist, daß ferner eine Gruppe von Steuerschaltungen vorgesehen ist, daß dabei jede Steuerschaltung zwei wechselzeitig betätigbare Ausgänge aufweise, daß dabei die einen Ausgänge der Steuerschaltungen mit den Bit-/Abfühlleitungen der einen Gruppe von Speicherkondensatoren und die anderen Ausgänge die gleichen Steuerschaltungen mit den Bit-/Abfühlleitungen der anderen Gruppe verbunden sind, daß zur abwechselnden Auswahl der einzelnen Gruppen Ladungsspeicherquellen und Auswahlspannungsimpulsquellen vorgesehen sind, und daß jede der Steuerschaltungen zur Anschaltung der einen bzw. der anderen Bit-/Abfühlleitungsgruppen an Dateneingangs-/Ausgangsleitungen über Steuereingangsklemmen ansteuerbar its.

Die Erfindung wird nunmehr anhand von Ausführungsbeispielen in Verbindung mit den beigefügten Zeichnungen im einzelnen erläutert.

In den Zeichnungen zeigt

Fig. 1 eine Schnittansicht einer Ausführungsform einer erfindungsgemäß aufgebauten Speicheranordnung mit daran angeschlossenen Steuer- und Auswahlschaltungen,

Fig. 2 ein Impulsdiagramm für den Betrieb der in Fig. 1 dargestellten Anordnung,

Fig. 3 eine Speicheranordnung mit den auf beiden Seiten der Speicheranordnung angeordneten Steuerschaltungen,

Fig. 4 eine ähnliche Speicheranordnung wie in Fig. 3, jedoch unter Verwendung von besonderen Schaltverfahren zur Erhöhung der durch eine gegebene Anzahl von Steuerschaltungen bedienbaren Anzahl von Bit/Abfühl-Leitungen, und

Fign. 5, 6 und 7 Schnittansichten von verschiedenen Ausführungsformen der in Fig. 1 der Zeichnungen dargestellten Speicheranordnung.

*Beschreibung der bevorzugten Ausführungsformen*

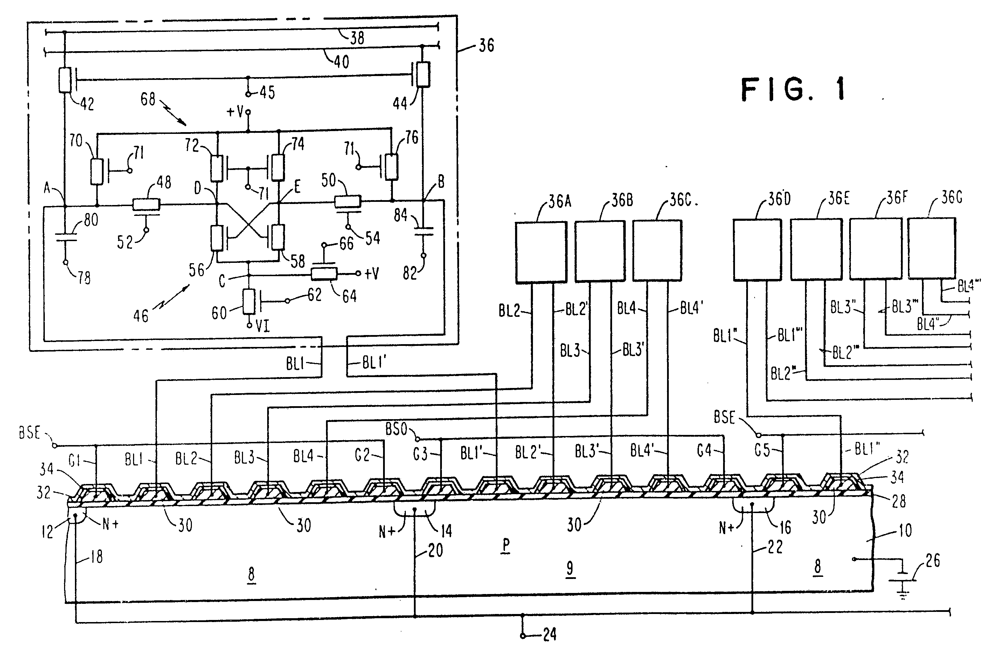

In Fig. 1 ist eine Speicheranordnung mit einem Halbleitersubstrat 10 dargestellt, in dem Diffusionszonen 12, 14 und 16 vorgesehen sind. Das Substrat kann dabei aus P-leitendem Material sein, während dann die Diffusionszonen 12, 14 und 16 aus $N^+$-leitendem Material sind. Leitungszüge 18, 20 und 22 verbinden eine Anschlußklemme 24 für eine Impulsquelle mit den Diffusionszonen 12, 14 bzw. 16 zum Anlegen von Ladungsimpulsen an diese Diffusionszonen. Eine Vorspannungsquelle 26 ist an dem Substrat 10 angeschlossen. Auf der Oberfläche des Substrats 10 ist eine erste Isolierschicht 28 vorgesehen, die beispielsweise aus Siliciumdioxid bestehen kann. Über dieser Isolierschicht 28 ist eine elektrisch leitende Anordnung vorgesehen, die aus senkrecht zur Zeichenebene verlaufenden parallelen, elektrisch leitenden Streifen 30 besteht. Das elektrisch leitende Material ist vorzugsweise polykristallines Silicium, kurz Polysilicium. Vier an den Bit/Abfühl-Leitungen BL1, BL2, BL3 und BL4 angeschlossene Leiterstreifen 30 definieren die Speicherzellen in der Anordnung, während zwei an den Leitungen G1 und G2 angeschlossene Leiterstreifen 30, die jeweils zu beiden Seiten der Gruppe der Bit/Abfühl-Leitungen BL1 bis BL4 angeordnet sind, als Gate-Elektroden für das Abfließen von Ladungen von der Diffusionszone 12 und der Diffusionszone 14 benutzt werden. Die Gate-Elektroden G1 und G2 sind an einer geradzahligen Byte-Auswahl-Spannungsimpulsquelle BSE angeschlossen. Zwischen den Diffusionszonen 14 und 16 ist eine zweite Gruppe von Leiterstreifen 30 und den Bit/Abfühl-Leitungen BL1', BL2', BL3' und BL4' angeschlossen. Die Gate-Elektroden G3 und G4 sind an einer ungeradzahligen Byte-Auswahl-Spannungsimpulsquelle BSO angeschlossen und steuern das Abfließen von Ladungen von der Diffusionszone 14 bzw. 16. Ähnliche Gruppen von Leiterstreifen 30, die an den Bit/Abfühlleitungen angeschlossen sind, können auf dem Substrat gebildet werden, wie dies bei G5 und BL1'' angedeutet ist. Eine beispielsweise aus mit Kupfer dotiertem Aluminium oder Polysilicium bestehende Wortleitung 32 ist über jedem der Leiterstreifen 30 und über zwischen den Leiterstreifen 30 liegende Teile der ersten Isolierschicht 28 angeordnet. Die Wortleitung 32 erstreckt sich senkrecht zur Richtung der Leiterstreifen 30 und ist von diesen Leiterstreifen 30 durch eine zweite Isolierschicht 34 isoliert. Die Wortleitung 32 ist dabei in Segmente oder Bytes unterteilt, die durch die zwischen zwei aufeinander folgenden Diffusionszonen, wie z.B. die Diffusionszonen 12 und 14 liegenden Zellen definiert sind, die dann als ein geradzahliges Byte mit dem Bezugszeichen 8 angesehen werden können, während die anderen Bytes, wie z.B. das Byte zwischen den Diffusionszonen 14 und 16 als ein ungeradzahliges Byte 9 angesehen werden können.

Eine Steuerschaltung 36 ist an ihren Knotenpunkten A und B an die Bit/Abfühl-Leitungen BL1 und BL1' angeschlossen. Die Steuerschaltung 36 kann von bekannter Bauart sein. An den Knotenpunkten A und B sind über Feldeffekttransistoren 42 bzw. 44 Eingabe- und Ausgabedatenleitungen 38 bzw. 40 angeschlossen, während eine E/A-Steuerimpulsquelle über eine Eingangsklemme 45 an die Steuerelektrode der Transistoren 42 bzw. 44 angeschlossen ist. An den Knotenpunkten A und B ist außerdem eine Abfühlschaltung 46 über Isoliertransistoren 48 bzw. 50 angeschlossen. Auswahlimpulse für geradzahlige und ungeradzahlige Bytes werden den Klemmen 52 bzw. 54 zugeführt, die an den Steuerelektroden von Transistoren 48 bzw. 50 angeschlossen sind. Die Abfühlschaltung 46, die als Verriegelungsschaltung ausgebildet ist, besteht aus einem Paar kreuzgekoppelter Transistoren 56 und 58, deren Source-Elektroden an einen gemeinsamen Knotenpunkt geführt sind. Die Steuerelektrode des Transistors 58 ist über Knotenpunkt D an Transistor 48 angeschlossen, während die Steuerelektrode des Transistors 56 über Knotenpunkt E an Transistor 50 angeschlossen ist. Die Drain-Elektrode der Transistoren 56 bzw. 58 ist am Knotenpunkt D bzw. E. angeschlossen. Ein Transistor 60 ist mit seiner Steuerelektrode an einer Takteingangsklemme 62 angeschlossen und stellt eine Verbindung zwischen dem Knotenpunkt C und einer Potentialquelle VI her. Ein Transistor 64, an dessen Steuerelektrode ein Rückstelleingang angeschlossen ist, koppelt eine Spannung +V nach dem Knotenpunkt C. Eine Voraufladeschaltung 68 koppelt eine Spannung +V über die Transistoren 70, 72, 74 und 76 nach den Knotenpunkten A, D, E und B. Ein Voraufladeimpuls (PC) wird über eine Klemme 71 den Steuerelektroden der Transistoren 70, 72, 74 und 76 zugeführt. Eine Bezugssignalklemme 78 "ungerade" (OSR) ist über einen ersten Kondensator 80 an den Knotenpunkt D angekoppelt, während eine Bezugssignalklemme 82 "gerade" (ESR) über einen zweiten Kondensator an den Knotenpunkt E angekoppelt ist.

Man sieht, daß die an die beiden Bit/Abfühl-Leitungen BL1 und BL1' angekoppelte Steuerschaltung 36 eine Abfühlschaltung und eine Bit-Steuerstufe für die Bit/Abfühl-Leitungen BL1 und BL1' enthält. Eine ähnlich wie die Steuerschaltung 36 aufgebaute Steuerschaltung 36A ist für die Bit/Abfühl-Leitungen BL2 und BL2' vorgesehen, eine Steuerschaltung 36B ist für die Bit/Abfühl-Leitungen BL3 und BL3' vorgesehen und eine Steuerschaltung 36C ist für die Bit/Abfühl-Leitungen BL4 und BL4' vorgesehen. Ähnliche Steuerschaltungen 36D, 36E, 36F und 36G sind für die Bit/Abfühl-Leitungspaare BL1'' und BL1''', BL2'' und BL2''', BL3'' und BL3''' und BL4'' und BL4''' vorgesehen. Diese letztgenannten Bit/Abfühl-Leitungen sind an anderen Leiterstreifen 30 angeschlossen, wobei eine dieser Steuerschaltungen (36D) mit ihrem Anschluß an die Bit/Abfühl-Leitung BL1'' gezeigt ist. Diese anderen Bit/Abfühl-Leitungen bilden weitere der Wortleitung 32 zugeordnete Gruppen von Zellen oder Bytes und werden durch geradzahlige bzw. ungeradzahlige Byte-Auswahlimpulse angesteuert, wobei nur der Anschluß BSE der geradzahligen Byte-Auswahlimpulsquelle an die Gate-Elektrode G5 gezeigt ist.

Die grundsätzliche Arbeitsweise einer Speicheranordnung dieser Art ist in der Deutschen Patenanmeldung P 27 11 542.0 beschrieben. Wie dort ausgeführt, wird die Spannung einer Ladungsimpulsquelle, die normalerweise zum Zuführen eines Ladungsimpulses auf +8.0 Volt liegt, zu vorbestimmten Zeitpunkten oder Intervallen auf 0 Volt abgesenkt, so daß ein Strom von Ladungen zu fließen beginnt, während das Substrat vorzugsweise auf −3.0 Volt vorgespannt ist. Ein Wortimpuls, der zwischen −2.0 und +4.5 Volt schwankt, wird selektiv an eine Wortleitung angelegt und ein zum Einschreiben von Information in die Speicherzellen dienender Bit-Impuls hat ein Ruhepotential von +8.5 Volt und ein Potential von +4.5 Volt zum Einschreiben beispielsweise einer binären 1. Wenn zum Beispiel eine binäre 1 aus der Speicherzelle ausgelesen werden soll, dann tritt auf den Bit-Leitungen, bei denen eine 1 abgespeichert ist, ein relativ kräftiges Ladungssignal auf, das einen Spannungsimpuls von merklicher negativer Amplitude liefert, während die anderen Bit-Leitungen, auf denen eine binäre 0 eingespeichert ist, ein Signal aufnehmen, dessen Spannungsamplitude praktisch 0 ist. Solche Signale werden in jeder der Bit-Leitungen erzeugt, die die Streifenleiter 30 mit den Steuerschaltungen 36 verbinden.

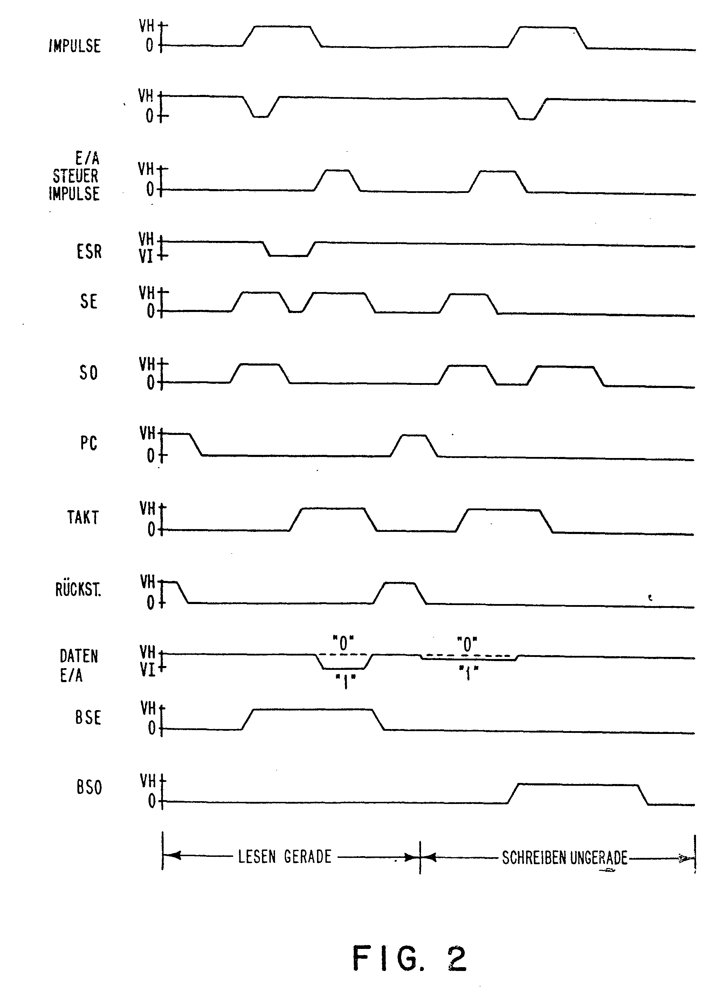

Für ein besseres Verständnis der Arbeitsweise der Speicheranordnung gemäß der Erfindung soll nunmehr auf das in Fig. 2 dargestellte Impulsdiagramm verwiesen werden. Zum Lesen von Information, die in den durch die Leiterstreifen 30 gebildeten Speicherzellen abgespeichert ist, an denen die Bit/Abfühl-Leitungen BL1, BL2, BL3 und BL4 angeschlossen sind, d.h. das geradzahlige Byte 8, werden die Steuerschaltungen 36, 36A, 36B bzw. 36C verwendet, wie dies Fig. 1 zeigt. Da die Steuerschaltungen 36 36A, 36B und 36C in gleichartiger Weise arbeiten, ist nur die Beschreibung der Arbeitsweise einer Steuerschaltung 36 erforderlich, die das auf der Bit/Abfühl-Leitung BL1 auftretende Signal Rückstellspannung VH über die Klemme 66 der Steuerelektrode des Transistors 64 zugeführt, wodurch eine Spannung von +V an den Knotenpunkt C angelegt wird. Die Spannung VH ist vorzugsweise wesentlich höher als die Spannung +V, so daß tatsächlich die gesamte Spannung +V am Knotenpunkt C liegt. Während der Rückstellimpuls den Knotenpunkt C auf das Potential +V auflädt, wird der Voraufladeimpuls PC über Klemme 71 sum Aufladen der Knotenpunkte A, D, E und B auf die Spannung +V an die Transistoren 70, 72, 74 und 76 angelegt. Der Voraufladeimpuls PC fällt kurz nach Abfallen des Rückstellimpulses auf 0 ebenfalls auf 0 Volt ab. Geradzahlige und ungeradzahlige Auswahlimpulse SE bzw. SO werden dann den Steuerelektroden der Transistoren 48 und 50 über Klemmen 52 bzw. 54 zugeleitet. Danach wird der Wortimpuls an die Wortleitung 32 angelegt, und der geradzahlige Byte-Auswahlimpuls BSE wird den Gateelektroden G1 und G2 zugeleitet, während eine Impulsquellenspannung an der Klemme 24 von der Spannung VH auf 0 Volt abfällt, so daß Elektronen oder Ladungsträger von den Diffusionszonen 12 und 14 nach den an den Bit-Leitungen BL1, BL2, BL3 und BL4 angeschlossenen Zellen abfließen können.

Nachdem die Diffusionszonen 12, 14 in dem Substrat, die den Bit/Abfühl-Leitungen BL1, BL2, BL3 und BL4 zugeordnet sind, mit Ladungsträgern aufgefüllt sind, nimmt der Aufladeimpuls weider die Amplitude von VH an und schaltet damit die Ladungsträgerquelle von den Diffusionszonen 12 und 14 ab, so daß als Überlauf noch vorhandene überschüssige Elektronen oder Ladungsträger in die Diffusionszonen 12 und 14 überlaufen. Zum Feststellen der in der an der Bit/Abfühl-Leitung BL1 angeschlossenen Zelle abgespeicherten Information wird eine geradzahlige Signalbezugsspannung ESR mit der Amplitude VI über die Klemme 82 zum Anlegen eines Bezugssignals über den Kondensator 84 an dem Knotenpunkt E zugeführt, wobei der Wert des Bezugssignals in der Mitte zwischen der Größe der binären Signale 0 und 1 liegt, die auf den Bit/Abfühl-Leitungen erzeugt werden. Nachdem die geradzahligen und ungeradzahligen Auswahlimpulse SE und SO ebgeschaltet sind, wird ein Taktimpuls über Klemme 62 an die Steuerelektrode des Transistors 60 angelegt, so daß die Spannung am Knotenpunkt C von +V nach einer tiefer liegenden Spannung VI abfällt, wobei diese Spannung nicht notwendigerweise die gleiche Amplitude zu haben braucht wie die ESR-Spannung VI, so daß dadurch die Abfühlschaltung 46 rasch in einen ihrer beiden Zustände eingeschaltet wird. Kurz danach wird der geradzahlige Auswahlimpuls SE erneut über die Klemme 52 der Steuerelektrode des Transistors 48 für eine Entladung der Bit/Abfühl-Leitung BL1 über die Transistoren 56 und 60 zugeführt für den Fall, daß das auf der Bit/Abfühlleitung BL1 liegende Signal im Vergleich mit der am Knotenpunkt E liegenden Spannung das geringere Potential hatte. Hätte die auf der Bit/Abfühl-Leitung BL1 liegende Spannung einen hohen Wert gehabt, d.h. höher als die am Knotenpunkt E liegende Spannung, dann hätte sich der Knotenpunkt E über die Transistoren 58 und 60 entladen und die Bit/Abfühl-Leitung BL1 wäre auf hohem Potential verblieben.

Wenn sich die Abfühlschaltung in einem gegebenen Zustand verriegelt hat, dann wird ein E/A-Steuerimpuls über die Eingangsklemme 45 den Steuerelektroden der Transistoren 42 und 44 zugeführt, wodurch die Daten oder die Spannung am Knotenpunkt D nach der E/A-Datenleitung 38 übertragen werden kann. Ist die auf der Datenleitung 38 liegende Spannung hoch, d.h. liegt sie bei etwa VH, so zwigt dies an, daß in der an der Bit/Abfühl-Leitung BL1 angeschlossenen Speicherzelle eine binäre 0 eingespeichert war. Ist dagegen die auf der E/A-Datenleitung 38 liegende Spannung niedrig, so zwigt dies an, daß in der an der Bit/Abfühl-Leitung BL1 angeschlossenen Speicherzelle eine binäre 1 abgespeichert war.

Während die Steuerschaltung 36 die in der an der Bit/Abfühl-Leitung BL1 angeschlossenen Speicherzelle abgespeicherte Information abfühlt, stellen die Steuerschaltungen 36A, 36B und 36C in gleicher Weise die in den an den Bit/Abfühl-Leitungen BL2, BL3 bzw. BL4 angeschlossenen Speicherzellen abgespeicherte Information fest. Nachdem diese Information nach der E/A-Datenleitung 38 übertragen ist, fällt der E/A-Steuerimpuls und der geradzahlige Auswahlimpuls SE, der Taktimpuls und der geradzahlige Byte-Auswahlimpuls BSE auf 0 Volt ab. Zum Abschließen des Lesevorgangs des Zyklus für die den geradzahligen Gruppen von Zellen oder Bytes der Wortleitung 32 zugeordnete Speicherzellen wird vor dem Beginn des Schreibabschnittes eines Zyklus zum Einschreiben der Zellen in der ungeradzahligen Gruppe von Zellen oder Bytes, die als Speicherzellen gekennzeichnet sind, die an den Bit/Abfühl-Leitungen BL1′, BL2′, BL3′ und BL4′ angeschlossen sind, ein Rückstellimpuls über die Klemme 66 der Steuerelektrode des Transistors 64 zugeführt, wodurch das Potential am Knotenpunkt C auf +V Volt ansteigt, während der Voraufladeimpuls PC den Steuerelektroden der Transistoren 70, 72, 74 und 76 zum Anlegen der Spannung +V Volt an den Knotenpunkten A, D, E und B zugeführt wird. Wenn das E/A-Datensignal, im allgemeinen in komplementärer Form, auf den E/A-Datenleitungen 38 und 40 liegt, d.h. entweder eine binäre 1 oder eine binäre 0, dann wird ein E/A-Steuerimpuls über die Klemme 45 den Steuerelektroden der Transistoren 42 und 44 zugeleitet und die geradzahligen und ungeradzahligen Auswahlimpulse SE und SO werden über die Klemme 52 bzw. 54 den Steuerelektroden der Transistoren 48 und 50 zugeführt, wodurch das auf den E/A-Datenleitungen 38 und 40 liegende Signal nach den Knotenpunkten D und E übertragen wird und die Abfühlschaltung in ihrem entsprechenden Zustand verriegelt. Die Amplitude des E/A-Datensignals sollte dabei klein gehalten werden, damit der Speicherinhalt nicht ausgewälter Speicherzellen auf der ausgewählten Wortleitung, wie z.B. die an der Bit/Abfühl-Leitung BL1 angeschlossene Speicherzelle, nicht störend beeinflußt wird, während über die Leitung BL1′ eingeschrieben wird. Der Taktimpuls wird über die Eingangsklemme 62 zum raschen Einschalten der Abfühlschaltung der Steuerelektrode des Transistors 60 zugeführt. Der Wortimpuls liegt wiederum an der Wortleitung 32, und die Spannung der an der Eingangsklemme 24 angeschlossenen Ladungsträgerquelle wird auf 0 Volt abgesenkt, damit Ladungsträger nach den an den Bit/Abfühl-Leitungen BL1′, BL2′, BL3′ und BL4′ angeschlossenen Speicherzellen fließen können, nachdem der ungeradzahlige Byte-Auswahlimpuls BSO den Gate-Elektroden G3 und G4 zugeführt wurde. Die ungeradzahligen und geradzahligen Auswahlimpulse SO und SE werden abgeschaltet, während die Abfühlschaltung verriegelt wird, so daß die Abfühlschaltung von der großen Kapazität der Bit/Abfühl-Leitungen BL1 und BL1′ isoliert ist. Wenn die Information vom Knotenpunkt E nach der Bit/Abfühl-Leitung BL1′ übertragen wird, dann wird der ungerade Auswahlimpuls 50 wieder eingeschaltet. Es sei erneut darauf verwiesen, daß die Steuerschaltung 36 zum Einschreiben von Information in diejenige Speicherzelle benutzt wird, an der die Bit/Abfühl-Leitung BL1′ angeschlossen ist, und daß die Steuerschaltungen 36, 36A, 36B und 36C zum Einspeichern oder Einschreiben von Information in die an die Bit/Abfühl-Leitungen BL2′, BL3′ bzw. BL4′ angeschlossenen Speicherzellen dienen. Man erkennt, daß zwar nur vier Zellen durch die Steuerschaltungen 36, 36A, 36B und 36C angesteuert werden, daß jedoch andere Speicherzellen als die an der Bit/Abfühl-Leitung BL1 angeschlossene Speicherzelle durch andere Steuerschaltungen, wie zum Beispiel die Steuerschaltungen 36D, 36E, 36F und 36G, angesteuert werden.

Daher sei darauf hingewiesen, daß in der in Fig. 1 dargestellten Ausführungsform der Erfindung die eine Hälfte der der Wortleitung 32 zugeordneten Speicherzellen während eines ersten Zeitabschnitts gleichzeitig angesteuert werden, während die zweite Hälfte dieser Speicherzellen während eines zweiten Zeitabschnitts angesteuert werden. Man sieht ferner, daß zwar vier Zellen hier eine Gruppe oder ein Informations-Byte bilden, daß jedoch mehr als vier Zellen zu einer Gruppe oder einem Byte zusammengefaßt werden können. Es sei ferner vermerkt, daß die Steuerschaltung 36 an beiden Bit/Abfühl-Leitungen BL1 und BL1' angeschlossen ist und daß dann, wenn die Steuerschaltung 36 ein Signal aus der an der Bit/Abfühl-Leitung BL1 angeschlossenen Speicherzelle abfühlt, die Bit/Abfühl-Leitung BL1' mit ihrer daran angeschlossenen Speicherzelle blind mitläuft, um damit alle Störimpulse, die auf der Bit/Abfühl-Leitung BL1 erzeugt werden könnten, kompensiert. Ebenso wird die Bit/Abfühl-Leitung BL1 als Kompensationsleitung für die Bit/Abfühl-Leitung BL1' dann benutzt, wenn die an der Bit/Abfühl-Leitung BL1' angeschlossene Speicherzelle abgefühlt wird. Es sei ferner darauf aufmerksam gemacht, daß ein ungeradzahliges Bezugssignal an der Klemme 78 angelegt wird, wenn das in der an der Bit/Abfühl-Leitung BI1' angeschlossenen Speicherzelle liegende Signal abgefühlt wird. Das Einschreiben von Information in die and die Bit/Abfühl-Leitung BL1 angeschlossene Speicherzelle und das Lesen von Information aus der an der Bit/Abfühl-Leitung BL1' angeschlossenen Speicherzelle läuft ähnlich ab, wie dies zuvor für das Lesen und Schreiben von Speicherzellen beschrieben wurde, die an den Bit/Abfühlleitungen BL1 bzw. BL1' angeschlossen waren.

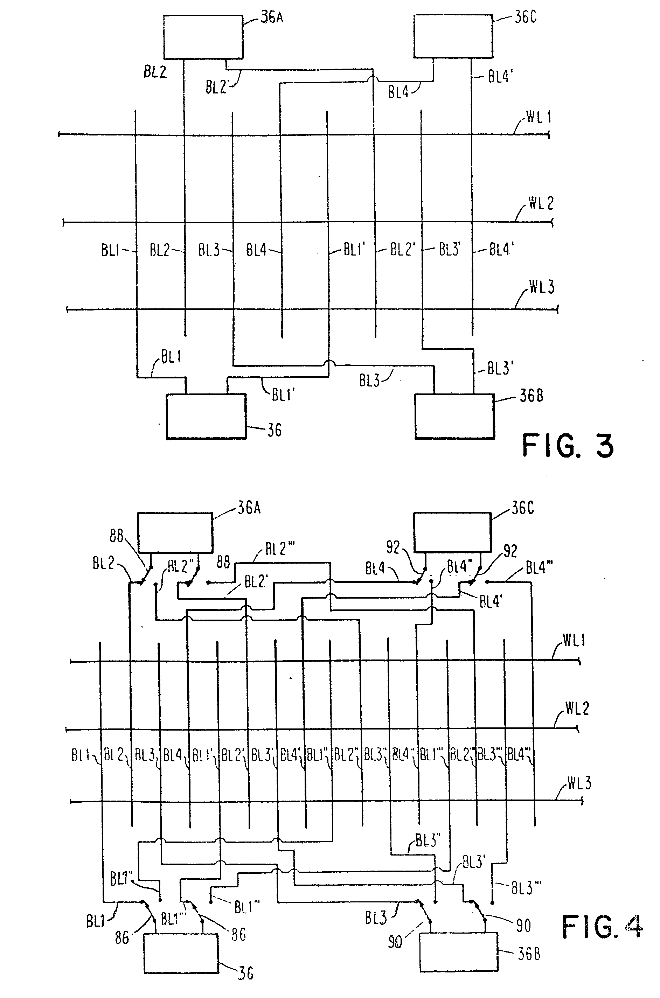

Fig. 3 zeigt schematisch eine Draufsicht einer erfindungsgemäß aufgebauten Speicheranordnung mit 8 Bit/Abfühl-Leitungen BL1, BL2, BL3, BL4, BL1', BL2', BL3' und BL4', denen drei Wortleitungen WL1, WL2 und WL3 zugeordnet sind. Man sieht, daß die Steuerschaltungen 36, 36A, 36B und 36C auf beiden Seiten der Speicheranordnung vorgesehen werden können, so daß beispielsweise die beiden Steuerschaltungen 36 und 36B auf einer Seite der Anordnung und die Steuerschaltungen 36A und 36C auf der anderen Seite der Anordnung liegen. Dadurch wird jede der Steuerschaltungen 36, 36A, 36B und 36C mit einer Abmessung entsprechend vier Bit/Abfühl-Leitungen und vier Abständen zwischen diesen Bit/Abfühl-Leitungen gebildet, so daß sich dadurch eine erhebliche Gestaltungsfreiheit für den Schaltungsentwurf eines geeigneten Abfühlverstärkers ergibt, der in der Lage ist, die kleinen aus den Speicherzellen stammenden Signale festzustellen.

Gemäß einem weiteren Merkmal der Erfindung zeigt Fig. 4 eine ähnlich wie Fig. 3 aufgebaute Speicheranordnung, bei der die vier Steuerschaltungen Zugriff zu 16 Bit/Abfühl-Leitungen BL1, BL2, BL3, BL4, BL1', BL2', BL3', BL4', BL1'', BL2'', BL3'', BL4'', BL1''', BL2''', BL3''' und BL4''' dadurch erreichen, daß entsprechende Umschalter (86, 88, 90, 92) vorgesehen sind, während trotzdem alle Vorteile der Störimpulsbeseitigung erhalten bleiben, die im Zusammenhang mit der anderen Ausführungsform der Erfindung erwähnt wurde. Man sieht, daß durch Anschluß der Steuerschaltungen 36, 36A, 36B und 36C an die Bit/Abfühl-Leitungen über zweipolige Umschalter 86, 88, 90 und 92 die vier Steuerschaltungen 36, 36A, 36B und 36C die von den Bit/Abfühl-Leitungen BL1, BL2, BL3, BL4, BL1', BL2', BL3' und BL4' kommenden Signale abfühlen können, wenn sich die Schalter in ihrer ersten Schaltposition befinden und in einer zweiten Schaltposition können dann die vier Steuerschaltungen 36, 36A, 36B und 36C, die von den Bit/Abfühl-Leitungen BL1'', BL2'', BL3'', BL4'', BL1''', BL2''', BL3''' und BL4''' kommenden Signale abfühlen. Daher sind für die Abfühlung von Signalen auf 16 Bit/Abfühl-Leitungen insgesamt nur vier Abfühlschaltungen erforderlich. Diese Anordnung gestattet den Aufbau eines Abfühlverstärkers und der zugehörigen Treiberschaltungen auf einer Fläche auf einem Halbleitersubstrat, welche durch 8 Bit/Abfühl-Leitungen definiert its. Selbstverständlich kann jeder der Umschalter 86, 88, 90 und 92 so ausgestaltet werden, daß er zwei oder mehr Positionspaare statt nur dem einen Positionspaar in Fig. 4 aufweist, so daß viel mehr als 16 Bit/Abfühl-Leitungen durch die vier Steuerschaltungen 36, 36A, 36B und 36C bedient werden können.

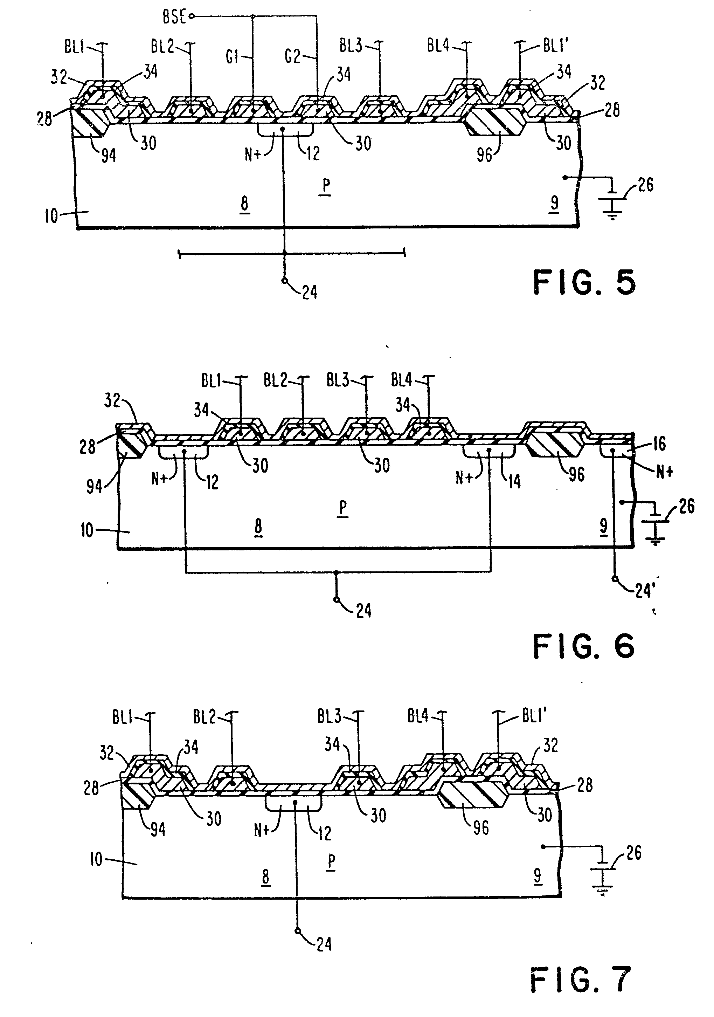

Fign. 5, 6 und 7 zeigen Schnittansichten weiterer Ausführungsformen der Speicheranordnung gemäß Fig. 1 mit gleichen Bezugszeichen für gleichartige Teile. In der in Fig. 5 gezeigten Ausführungsform ist eine einzige Ladungsträgerquelle an der Diffusionszone 12 zwischen den beiden vertieft liegenden Oxidzonen 94 und 96 gezeigt. Die vertieft liegenden Oxidzonen 94 und 96 haben die Aufgabe, die Übertragung von Ladungsträgern von der Diffusionszone 12 nach den an den Bit/Abfühl-Leitungen BL1, BL2, BL3 und BL4 angeschlossenen Speicherzellen zu verhindern. Die vertieft angeordneten Oxidzonen 94 und 96 dienen daher als Ladungs-Isolationssperrschichten. Jeder der Diffusionszonen, wie der Diffusionszone 12 und dem Substrat 10 wird ein Ladungsträgerimpuls über die Klemme 24 zugeführt und das Byte oder die Bytes der Wortleitung werden durch einen geradzahligen Byte-Auswahlimpuls BSE oder durch einen ungeradzahligen Byte-Auswahlimpuls BSO angesteuert, wobei das Byte 8 durch Anlegen des geradzahligen Byte-Auswahlimpulses BSE an die Gate-Elektroden G1 und G2 in Fig. 5 ausgewählt wird.

Die in Fig. 6 dargestellte Ausführungsform unterscheidet sich von der in Fig. 1 gezeigten Ausführungsform dadurch, daß in der Nachbarschaft der vertieft liegenden Oxidzonen 94 bzw. 96 je eine Diffusionszone 12 bzw. 14 angeordnet ist, wobei die Speicherzellen, die an den Bit/Abfühl-Leitungen BL1, BL2, BL3 und BL4 angeschlossen sind, zwischen den beiden Diffusionszonen 12 und 14 liegen. Weiterhin bewirkt der Ladungsträgerimpuls hier die Auswahl der Bytes. Daher wird ein Ladungsträgerimpuls über Klemme 24 zur Auswahl des Bytes 8 an die Diffusionszonen 12 und 14 angelegt, während ein zweiter Ladungsträgerimpuls über eine Klemme 24' anderen Diffusionszonen mit der Diffusionszone 16 zur Auswahl des Bytes 9 zugeführt werden. In dieser Ausführungsform werden die Impulse BSE und BSO nicht benötigt.

In der in Fig. 7 dargestellten Ausführungsform wählt der an der Klemme 24 zugeführte Ladungsträgerimpuls ebenfalls das Byte aus, doch wird dieser Impuls lediglich einer Diffusionszone 12 innerhalb eines Bytes zugeführt, welches in diesem Fall zwischen den an der Bit/Abfühl-Leitung BL2 und an der Bit/Abfühl-Leitung BL3 angeschlossenen Speicherzellen liegt.

In Fign. 5, 6 und 7 sind vertieft angeordnete Oxidzonen 94 und 96 als Ladungsträgersperrschichten dargestellt, man könnte jedoch auch Erdungsebenen als Sperrschichten einführen, wie dies beispielsweise in den US—A—schriften 3 811 076 und 3 841 926 beschrieben ist.

Man sieht, daß verschiedene Kombinationen von Byte-Auswahlverfahren für eine bestimmte Wortleitung eingesetzt werde können, mit verschiedenen Kombinationen von Steuergates und Ladungsträgerquellen, ohne dabei vom Schutzbereich der Erfindung abzuweichen. Es sie ferner darauf hingewiesen, daß auch eine Speicherschaltung vom Schutzbereich der Erfindung umfaßt werden soll, bei der eine kleine Anzahl einer Wortleitung zugeordneter Speicherzellen, wie z.B. ein Byte zum Lesen und Schreiben ausgewählt werde können, ohne daß dadurch andere Zellen an dieser Wortleitung störend beeinflußt werden. Bei Einsatz dieses Verfahrens ist die kleinste Abstandsweite eines Abfühlverstärkers gleich dem Mehrfachen der Abmessung des Bit-Leitungsabstandes in der Speicheranordnung.

## Patentansprüche

1. Kapazitiver, integrierter Halbleiterspeicher mit auf einem Halbleitersubstrat (10) angeordneten, über Wort- und Bitleitungen (WL, BL) ansteuerbaren Speicherzellen sowie mit einer Anzahl Steuerschaltungen (36) zum Einschreiben und Auslesen von Information, bei welchem auf dem Halbleitersubstrat (10) eine erste Isolierschicht (28) und zur Bildung von Speicherkondensatoren über dieser eine Anzahl von parallel verlaufenden, voneinander auf Abstand liegenden Leiterstreifen (30) vorgesehen sind, die über die Bit/Abfühlleitungen (BL) mit den Steuerschaltungen (36) verbunden sind, während über einer weiteren Isolierschicht (34) zu den Leiterstreifen (30) orthogonal verlaufende Wortleitungen (WL; 32) vorgesehen sind, wobei in dem Halbleitersubstrat die Anordnung der Speicherkondensatoren zu beiden Seiten durch eine Diffusionszone (12, 14) begrenzt ist, die über eine Impulsquelle ansteuerbar ist, dadurch gekennzeichnet, daß die Leiterstreifen (30) jeweils zu Gruppen (8, 9) zusammengefaßt sind, wobei jede Gruppe jeweils zwischen zwei Diffusionszonen (12, 14 bzw. 14, 16 bzw. 16...) angeordnet ist,

daß ferner eine Gruppe von Steuerschaltungen (36, 36A, 36B, 36C) vorgesehen ist,

daß dabei jede Steuerschaltung (36) zwei wechselzeitig betätigbare Ausgänge aufweist,

daß dabei die einen Ausgänge der Steuerschaltungen mit den Bit-/Abfühlleitungen (BL1 bis BL4) der einen Gruppe (8) von Speicherkondensatoren und die anderen Ausgänge die gleichen Steuerschaltungen mit den Bit-/Abfühlleitungen (BL1' bis BL4') der anderen Gruppe verbunden sind,

daß zur abwechselnden Auswahl der einzelnen Gruppen (8 oder 9) Ladungsspeicherquellen (12, 14, 16, 18, 20, 22, 24) und Auswahlspannungsimpulsquellen (BSE bzw. BSO) vorgesehen sind, und

daß jede der Steuerschaltungen zur Anschaltung der einen bzw. der anderen Bit-/Abfühlleitungsgruppen an Dateneingangs-/Ausgangsleitungen (38, 40) über Steuereingangsklemmen (52, 54) ansteuerbar ist.

2. Halbleiterspeicher nach Anspruch 1, dadurch gekennzeichnet,

daß vier Gruppen mit je vier Speicherkondensatoren vorgesehen sind, die über vier Gruppen von Bit-/Abfühlleitungen (BL1 bis BL4, BL1' bis BL4', BL1'' bis BL4'', BL1''' bis BL4''') ansteuerbar sind und

daß vier Steuerschaltungen (36) mit je zwei Ausgängen über je einen Umschalter (86, 88, 90, 92) in der Weise an die Gruppen von Bit-/Abfühlleitungen anschaltbar sind,

daß über die vier Umschalter jeweils immer nur eine Gruppe von Bit-/Abfühlleitungen (z.B. BL1 bis BL4) angeschlossen ist, und

daß diese Umschalter gemeinsam umschaltbar sind.

3. Halbleiterspeicher nach Anspruch 1 und 2, dadurch gekennzeichnet,

daß zu beiden Seiten einer jeden Gruppe von die Speicherkondensatoren bildenden Leiterstreifen (30) jeweils ein weiterer Leiterstreifen (30) vorgesehen ist, der als Gateelektrode (G1, G2, G3, G4, G5) dient, und daß die zwei Gateelektroden (z.B. G1, G2 bzw. G3, G4) einer jeden Gruppe miteinander verbunden und durch Auswahlspannungsimpulsquellen (BSE, BSO) zur Auswahl der entsprechenden Gruppe (8, 9) ansteuerbar sind.

4. Halbleiterspeicher nach Anspruch 1 bis 3, dadurch gekennzeichnet,

daß jede der Steuerschaltungen (36) einen Abfühlverstärker (46) und für jeden der Bit-/Abfühlleitungsausgänge eine Bit-Treiberstufe aufweist.

5. Halbleiterspeicher nach Anspruch 1 bis 4, dadurch gekennzeichnet,

daß an jeder Steuerschaltung (36) zwei Bezugspotentialquellen (ESR bzw. OSR) angekoppelt sind.

## Revendications

1. Mémoire semi-conductrice intégrée capacitive comportant des cellules de mémoire disposées sur un substrat semi-conducteur (10) et adressables par des lignes de mot (WL) et des lignes de bit (BL), et un certain nombre de circuits de commande (36) pour écrite et lire des données, qui prévoit sur le substrat semi-conducteur (10) une première couche isolante (28) et sur celle-ci un certain nombre de bandes conductrices (30) parallèles et espacées les unes par rapport aux autres pour former des condensateurs de mémoire, lesdites bandes étant connectées avec les circuits de commande (30) à travers les lignes de bit/détection (BL), et qui prévoit sur une autre couche isolante (34) sont prévues des lignes de mot (WL, 32) disposées orthogonalement par rapport aux bandes conductrices (30), les condensateurs de mémoire dans le substrat semi-conducteur étant limités des deux côtés par une région de diffusion (12, 14) adressable par une source d'impulsion, caractérisée:

en ce que les bandes conductrices (30) sont réunies en groupes (8, 9), chaque groupe étant disposé entre deux regions de diffusion (12, 14; ou 14, 16; ou 16,...),

en ce que l'on prévoit un groupe de circuits de commande (36, 36A, 36B, 36C),

en ce que chaque circuit de commande (36) comporte deux sorties fonctionnant alternativement,

en ce que les premières sorties des circuits de commande sont connectées avec les lignes de bit/détection (BL1 à BL4) de l'un des groupes (8) des condensateurs de mémoire et les secondes sorties des mêmes circuits de commande sont connectées avec les lignes de bit/détection (BL1' à BL4') de l'autre groupe,

en ce que l'on prévoit des sources de mémoire de charge (12, 14, 16, 18, 20, 22, 24) et de sources d'impulsion de tension de sélection (BSE et BSO respectivement) pour sélectionner alternativement les différents groupes (8 ou 9), et

en ce que chacun des circuits de commande est adressable par des bornes de commande d'entrée (52, 54) pour connecter l'un ou l'autre des groupes de lignes de bit/détection aux lignes d'entrée/sortie de données (38, 40).

2. Mémoire semi-conductrice selon la revendication 1, caractérisée:

en ce qu l'on prévoit quatre groupes ayant chacun quatre condensateurs de mémoire adressables par quatre groupes de lignes de bit/détection (BL1 à BL4, BL1' à BL4', BL1'', à BL4'', BL1''', à BL4'''),

en ce que quatre circuits de commande (36) ont chacun deux sorties connectées par un commutateur (86, 88, 90, 92) aux groupes de lignes de bit/détection de telle sorte qu'un seul groupe de lignes de bit/détection (par exemple BL1 à BL4) est connecté à travers les quatre commutateurs, et

en ce que ces commutateurs peuvent être commutés en commun.

3. Mémoire semi-conductrice selon les revendications 1 et 2 charactérisée:

en ce que l'on prévoit des deux côtés de chaque groupe de bandes conductrices (30) formant les condensateurs de mémoire, une bande conductrice supplémentaire (30) servant d'électrode de porte (G1, G2, G3, G4, G5), et

en ce que les deux électrodes de porte (par exemple G1, G2 ou G3, G4) de chaque groupe sont interconnectées et adressables par les sources d'impulsions de tension de sélection (BSE, BSO) pour sélectionner les groupes correspondants (8, 9).

4. Mémoire semi-conductrice selon les revendications 1 à 3, caractérisée en ce que chacun des circuits de commande (36) comporte un amplificateur de détection (46) et, pour chacune des sorties des lignes de bit/détection, un étage de commande de bit.

5. Mémoire semi-conductrice selon les revendications 1 à 4, caractérisée en ce que deux sources de potentiel de référence (ESR et OSR respectivement) sont couplées avec chaque circuit de commande (36).

**Claims**

1. Capacitive integrated semiconductor memory, employing memory cells arranged on a semiconductor substrate (10) and addressable via word lines (WL) and bit lines (BL), and a plurality of control circuits (36) for reading and writing of information, wherein a first insulation layer (28) is provided on said substrate (10) and a plurality of parallel spaced conductive strips (30) (are provided) on top of said insulation layer to form storage capacitors, said conductive strips (30) being connected to the control circuits via bit/sense lines (BL), while word lines (WL, 32) are provided in orthogonal direction relative to the conductive strips (30) on top of a further insulation layer (34) so that the storage capacitor array in the semiconductor substrate is limited on both sides by a diffusion region (12, 14) addressable via a pulse source, characterized in that the conductive strips (30) are combined in groups (8, 9) each group being arranged between two diffusion regions (12, 14 or 14, 16 or 16,...), that a group of control circuits (36, 36A, 36B, 36C) is provided, that the outputs of each control circuit (36) can be operated at alternate times, that first outputs of the control circuits are connected to the bit/sense lines (BL1 to BL4) of one group (8) of storage capacitors, and that second outputs of the same control circuits are connected to the bit/sense lines (BL1' to BL4') of the other group, that charge storage sources (12, 14, 16, 18, 20, 22, 24) and selection voltage pulse sources (BSE and BSO resp.) are provided for the alternate selection of the individual groups (8 or 9), and that each control circuit can be addressed via control input terminals (52, 54) to connect one or the other group of bit/sense lines to data input/output lines (38, 40).

2. Semiconductor memory according to claim 1, characterized in that four groups each comprising four storage capacitors and addressable via four groups of bit/sence lines (BL1 to BL4, BL1'

to BL4', BL1'', to BL4'', BL1''' to BL4''') are provided, that four control circuits (36) each with two outputs can be connected to the groups of bit/sense lines via an individual switch (86, 88, 90, 92) in such a way that only one group of bit/sense lines (e.g. BL1 to BL4) at a time is connected via said switches, and that said switches can be switched in common.

3. Semiconductor memory according to claims 1 and 2, characterized in that an additional conductive strip (30) is provided as a gate electrode (G1, G2, G3, G4, G5) on both sides of each group of conductive strips (30) forming the storage capacitors, and that the two gates (e.g. G1, G2 or G3, G4) of each group are interconnected with one another, and the corresponding group (8, 9) can be addressed for selection by selection voltage pulse sources (BSE, BSO).

4. Semiconductor memory according to claims 1 to 3, characterized in that each control circuit (36) comprises a sense amplifier (46) and a bit driver stage for every bit/sense line output.

5. Semiconductor memory according to claims 1 to 4, characterized in that two reference potential sources (ESR and OSR resp.) are coupled to each control circuit (36).

FIG. 1

FIG. 2

FIG. 3

FIG. 4

FIG. 5

FIG. 6

FIG. 7